(19) Europäisches Patentamt
European Patent Office
Office européen des brevets

(11) **EP 4 730 033 A1**

(12) **EUROPEAN PATENT APPLICATION**

(43) Date of publication:
22.04.2026 Bulletin 2026/17

(21) Application number: 24207279.1

(22) Date of filing: 17.10.2024

(51) International Patent Classification (IPC):
*G03F 7/00* (2006.01)

(52) Cooperative Patent Classification (CPC):
G03F 7/70616; G03F 7/705; G03F 7/70516;
G03F 7/70525

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(71) Applicant: ASML Netherlands B.V.
5500 AH Veldhoven (NL)

(72) Inventor: URBANCZYK, Adam, Jan
5500 AH Veldhoven (NL)

(74) Representative: ASML Netherlands B.V.
Corporate Intellectual Property
P.O. Box 324
5500 AH Veldhoven (NL)

(54) **METHOD OF CALIBRATING A YIELD MODEL, ASSOCIATED APPARATUS AND COMPUTER PROGRAM**

(57) Disclosed is a method for calibrating a prediction model for predicting a failure probability of a device manufactured by a semiconductor manufacturing process based on performance parameter data relating to a performance parameter of said device. The method comprises obtaining calibration performance parameter data and corresponding reference data; optimizing one or more calibration parameters of the prediction model so as to improve prediction performance of said prediction model,

wherein said one or more calibration parameters comprises one or more of: an upper specification calibration parameter or an upper specification delta calibration parameter thereof, a lower specification calibration parameter or lower specification delta calibration parameter thereof, a scaling calibration parameter for scaling a scale parameter of the prediction model, a location parameter nuisance calibration parameter, a skewness calibration parameter and/or a kurtosis calibration parameter.

Fig. 3

**Description**

Field

The present invention relates to a lithographic process for the manufacture of integrated circuits and more specifically to a method of calibrating a yield model for predicting yield of such a lithographic process, an associated apparatus and a computer program.

Background

A lithographic apparatus is a machine that applies a desired pattern onto a substrate, usually onto a target portion of the substrate. A lithographic apparatus can be used, for example, in the manufacture of integrated circuits (ICs). In that instance, a patterning device, which is alternatively referred to as a mask or a reticle, may be used to generate a circuit pattern to be formed on an individual layer of the IC. This pattern can be transferred onto a target portion (e.g. comprising part of, one, or several dies) on a substrate (e.g. a silicon wafer). Transfer of the pattern is typically via imaging onto a layer of radiation-sensitive material (resist) provided on the substrate. In general, a single substrate will contain a network of adjacent target portions that are successively patterned. Known lithographic apparatus include so-called steppers, in which each target portion is irradiated by exposing an entire pattern onto the target portion at one time, and so-called scanners, in which each target portion is irradiated by scanning the pattern through a radiation beam in a given direction (the "scanning"-direction) while synchronously scanning the substrate parallel or anti-parallel to this direction. It is also possible to transfer the pattern from the patterning device to the substrate by imprinting the pattern onto the substrate.

Whichever type of apparatus is employed, the accurate placement of patterns on the substrate is a chief challenge for reducing the size of circuit components and other products that may be produced by lithography. In particular, the challenge of measuring accurately the features on a substrate which have already been laid down is a critical step in being able to position successive layers of features in superposition accurately enough to produce working devices with a high yield. So-called overlay should, in general, be achieved within a few tens of nanometers in today's sub-micron semiconductor devices, down to a few nanometers in the most critical layers.

To monitor and control this accurate placement of patterns, metrology may be performed using a metrology tool to measure one or more characteristics of the applied pattern or of metrology targets representing the applied pattern. The metrology tool may be based on optical measurement of the position and/or dimensions of the pattern and/or targets. It is intrinsically assumed that these optical measurements are representative for a quality of the process of manufacturing of the devices.

In addition or alternatively to control based on optical measurements, e-beam based measurements may be performed. One such metrology technique obtains images of the structures using an e-beam metrology tool. Another approach comprises voltage contrast inspection using an e-beam tool. Such a voltage contrast inspection can be indicative of the quality of electrical contact between layers applied to the substrate.

Voltage contrast inspection is very slow and therefore is typically not used be used for continuous monitoring of yield (failure probability). Instead, other metrology (scatterometer or e-beam imaging metrology) may be performed to measure a performance parameter such as edge placement error (EPE), from which failure probability or yield can be inferred using a statistical prediction model.

It is desirable to improve methods for predicting failure or yield using such a statistical prediction model.

Summary

In a first aspect of the invention there is provided a method for calibrating a prediction model for predicting a failure probability of a device manufactured by a semiconductor manufacturing process based on performance parameter data relating to a performance parameter of said device, the method comprising: obtaining calibration performance parameter data comprising values for the performance parameter; obtaining reference data corresponding to said calibration performance parameter data; optimizing one or more calibration parameters of the prediction model so as to improve prediction performance of said prediction model in predicting said reference data based on said calibration performance parameter data; wherein said one or more calibration parameters comprises one or more of: an upper specification calibration parameter or an upper specification delta calibration parameter thereof, a lower specification calibration parameter or lower specification delta calibration parameter thereof, a scaling calibration parameter for scaling a scale parameter of the prediction model, a location parameter nuisance calibration parameter, a skewness calibration parameter and/or a kurtosis calibration parameter.

In a second aspect of the invention there is provided a method for predicting a failure probability of a device manufactured by a semiconductor manufacturing process based on performance parameter data relating to a performance parameter of said device, the method comprising: obtaining performance parameter data comprising values for the performance parameter; obtaining a prediction model for which one or more calibration parameters of the prediction model have been calibrated; wherein said one or more calibration parameters comprises one or more of: an upper specification calibration parameter or an upper specification delta calibration parameter thereof, a lower specification calibration parameter or lower specification delta calibration parameter thereof, a scaling calibration parameter for scaling a scale parameter of the prediction model, a location parameter nuisance calibration parameter, a skewness calibration parameter and/or a kurtosis calibration parameter.

These and other features and advantages of particular embodiments of the invention will be understood by the skilled reader from a consideration of the exemplary embodiments discussed below.

## BRIEF DESCRIPTION OF THE DRAWINGS

Embodiments of the invention will now be described, by way of example only, with reference to the accompanying schematic drawings in which corresponding reference symbols indicate corresponding parts, and in which:

Figure 1(a) depicts a lithographic apparatus according to an embodiment of the invention;
Figure 1(b) illustrates schematically the stages in the measurement and exposure processes in the apparatus of Figure 1(a), according to known practice;
Figure 2 is a flowchart describing a method of determining a noise hyperparameter for regularizing an optimization according to concepts disclosed herein;
Figure 3 is a flowchart describing a method for calibrating and using a using a statistical prediction model according to concepts disclosed herein; and
Figure 4 illustrates computer system hardware useful in implementing the processes disclosed herein.

## DETAILED DESCRIPTION OF EXEMPLARY EMBODIMENTS

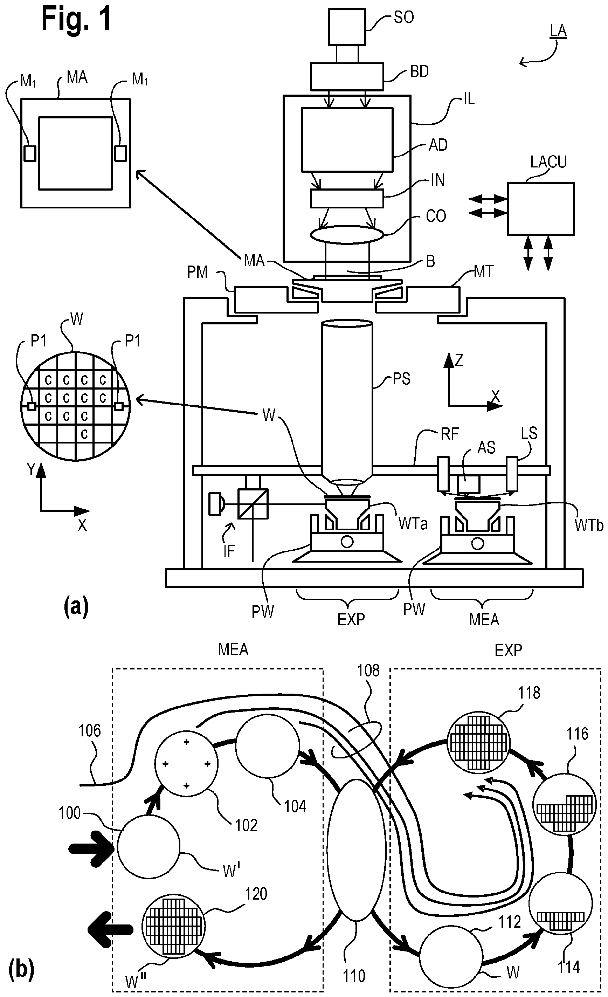

Figure 1(a) schematically depicts a lithographic apparatus LA according to one embodiment of the invention. The apparatus comprises:

- an illumination system (illuminator) IL configured to condition a radiation beam B (e.g. UV radiation or EUV radiation).
- a support structure (e.g. a mask table) MT constructed to support a patterning device (e.g. a mask) MA and connected to a first positioner PM configured to accurately position the patterning device in accordance with certain parameters;
- a substrate table (e.g. a wafer table) WTa or WTb constructed to hold a substrate (e.g. a resist-coated wafer) W and connected to a second positioner PW configured to accurately position the substrate in accordance with certain parameters; and
- a projection system (e.g. a refractive projection lens system) PS configured to project a pattern imparted to the radiation beam B by patterning device MA onto a target portion C (e.g. comprising one or more dies) of the substrate W.

The illumination system may include various types of optical components, such as refractive, reflective, magnetic, electromagnetic, electrostatic or other types of optical components, or any combination thereof, for directing, shaping, or controlling radiation.

The support structure supports, i.e. bears the weight of, the patterning device. It holds the patterning device in a manner that depends on the orientation of the patterning device, the design of the lithographic apparatus, and other conditions, such as for example whether or not the patterning device is held in a vacuum environment. The support structure can use mechanical, vacuum, electrostatic or other clamping techniques to hold the patterning device. The support structure may be a frame or a table, for example, which may be fixed or movable as required. The support structure may ensure that the patterning device is at a desired position, for example with respect to the projection system. Any use of the terms "reticle" or "mask" herein may be considered synonymous with the more general term "patterning device."

The term "patterning device" used herein should be broadly interpreted as referring to any device that can be used to impart a radiation beam with a pattern in its cross-section such as to create a pattern in a target portion of the substrate. It should be noted that the pattern imparted to the radiation beam may not exactly correspond to the desired pattern in the target portion of the substrate, for example if the pattern includes phase-shifting features or so called assist features. Generally, the pattern imparted to the radiation beam will correspond to a particular functional layer in a device being created in the target portion, such as an integrated circuit.

The patterning device may be transmissive or reflective. Examples of patterning devices include masks, programmable mirror arrays, and programmable LCD panels. Masks are well known in lithography, and include mask types such as binary, alternating phase-shift, and attenuated phase-shift, as well as various hybrid mask types. An example of a programmable mirror array employs a matrix arrangement of small mirrors, each of which can be individually tilted so as to reflect an incoming radiation beam in different directions. The tilted mirrors impart a pattern in a radiation beam which is reflected by the mirror matrix.

The term "projection system" used herein should be broadly interpreted as encompassing any type of projection system, including refractive, reflective, catadioptric, magnetic, electromagnetic and electrostatic optical systems, or any combination thereof, as appropriate for the exposure radiation being used, or for other factors such as the use of an immersion liquid or the use of a vacuum. Any use of the term "projection lens" herein may be considered as synonymous with the more general term "projection system".

As here depicted, the apparatus is of a transmissive type (e.g. employing a transmissive mask). Alternatively, the apparatus may be of a reflective type (e.g. employing a programmable mirror array of a type as referred to above, or employing a reflective mask).

The lithographic apparatus may be of a type having two (dual stage) or more substrate tables (and/or two or more mask tables). In such "multiple stage" machines the additional tables may be used in parallel, or preparatory steps may be carried out on one or more tables while one or more other tables are being used for exposure. The invention disclosed herein can be used in a stand-alone fashion, but in particular it can provide additional functions in the pre-exposure measurement stage of either single- or multi-stage apparatuses.

The lithographic apparatus may also be of a type wherein at least a portion of the substrate may be covered by a liquid having a relatively high refractive index, e.g. water, so as to fill a space between the projection system and the substrate. An immersion liquid may also be applied to other spaces in the lithographic apparatus, for example, between the mask and the projection system. Immersion techniques are well known in the art for increasing the numerical aperture of projection systems. The term "immersion" as used herein does not mean that a structure, such as a substrate, must be submerged in liquid, but rather only means that liquid is located between the projection system and the substrate during exposure.

Referring to Figure 1(a), the illuminator IL receives a radiation beam from a radiation source SO. The source and the lithographic apparatus may be separate entities, for example when the source is an excimer laser. In such cases, the source is not considered to form part of the lithographic apparatus and the radiation beam is passed from the source SO to the illuminator IL with the aid of a beam delivery system BD comprising, for example, suitable directing mirrors and/or a beam expander. In other cases the source may be an integral part of the lithographic apparatus, for example when the source is a mercury lamp. The source SO and the illuminator IL, together with the beam delivery system BD if required, may be referred to as a radiation system.

The illuminator IL may comprise an adjuster AD for adjusting the angular intensity distribution of the radiation beam. Generally, at least the outer and/or inner radial extent (commonly referred to as $\sigma$-outer and $\sigma$-inner, respectively) of the intensity distribution in a pupil plane of the illuminator can be adjusted. In addition, the illuminator IL may comprise various other components, such as an integrator IN and a condenser CO. The illuminator may be used to condition the radiation beam, to have a desired uniformity and intensity distribution in its cross-section.

The radiation beam B is incident on the patterning device (e.g., mask MA), which is held on the support structure (e.g., mask table MT), and is patterned by the patterning device. Having traversed the mask MA, the radiation beam B passes through the projection system PS, which focuses the beam onto a target portion C of the substrate W. With the aid of the second positioner PW and position sensor IF (e.g. an interferometric device, linear encoder or capacitive sensor), the substrate table WTa/WTb can be moved accurately, e.g. so as to position different target portions C in the path of the radiation beam B. Similarly, the first positioner PM and another position sensor (which is not explicitly depicted in Figure 1(a)) can be used to accurately position the mask MA with respect to the path of the radiation beam B, e.g. after mechanical retrieval from a mask library, or during a scan. In general, movement of the mask table MT may be realized with the aid of a long-stroke module (coarse positioning) and a short-stroke module (fine positioning), which form part of the first positioner PM. Similarly, movement of the substrate table WTa/WTb may be realized using a long-stroke module and a short-stroke module, which form part of the second positioner PW. In the case of a stepper (as opposed to a scanner) the mask table MT may be connected to a short-stroke actuator only, or may be fixed. Mask MA and substrate W may be aligned using mask alignment marks M1, M2 and substrate alignment marks P1, P2. Although the substrate alignment marks as illustrated occupy dedicated target portions, they may be located in spaces between target portions (these are known as scribe-lane alignment marks). Similarly, in situations in which more than one die is provided on the mask MA, the mask alignment marks may be located between the dies.

The depicted apparatus could be used in at least one of the following modes:

1. In step mode, the mask table MT and the substrate table WTa/WTb are kept essentially stationary, while an entire pattern imparted to the radiation beam is projected onto a target portion C at one time (i.e. a single static exposure). The substrate table WTa/WTb is then shifted in the X and/or Y direction so that a different target portion C can be exposed. In step mode, the maximum size of the exposure field limits the size of the target portion C imaged in a single static exposure.

2. In scan mode, the mask table MT and the substrate table WTa/WTb are scanned synchronously while a pattern imparted to the radiation beam is projected onto a target portion C (i.e. a single dynamic exposure). The velocity and direction of the substrate table WTa/WTb relative to the mask table MT may be determined by the (de-)magnification and image reversal characteristics of the projection system PS. In scan mode, the maximum size of the exposure field limits the width (in the non-scanning direction) of the target portion in a single dynamic exposure, whereas the length of the scanning motion determines the height (in the scanning direction) of the target portion.

3. In another mode, the mask table MT is kept essentially stationary holding a programmable patterning device, and the substrate table WTa/WTb is moved or scanned while a pattern imparted to the radiation beam is projected onto a target portion C. In this mode, generally a pulsed radiation source is employed and the programmable patterning device is updated as required after each movement of the substrate table WTa/WTb or in between successive radiation pulses during a scan. This mode of operation can be readily applied to maskless lithography that utilizes programmable patterning device, such as a programmable mirror array of a type as referred to above.

Combinations and/or variations on the above described modes of use or entirely different modes of use may also be employed.

Lithographic apparatus LA in this example is of a so-called dual stage type which has two substrate tables WTa and WTb and two stations - an exposure station and a measurement station-between which the substrate tables can be exchanged. While one substrate on one substrate table is being exposed at the exposure station EXP, another substrate can be loaded onto the other substrate table at the measurement station MEA so that various preparatory steps may be carried out. The preparatory steps may include mapping the surface of the substrate using a level sensor LS and measuring the position of alignment mark on the substrate using an alignment sensor AS. This enables a substantial increase in the throughput of the apparatus. If the position sensor IF is not capable of measuring the position of the substrate table while it is at the measurement station as well as at the exposure station, a second position sensor may be provided to enable the positions of the substrate table to be tracked at both stations. The invention can be applied in apparatus with only one substrate table, or with more than two.

The apparatus further includes a lithographic apparatus control unit LACU which controls all the movements and measurements of the various actuators and sensors described. LACU also includes signal processing and data processing capacity to implement desired calculations relevant to the operation of the apparatus. In practice, control unit LACU will be realized as a system of many subunits, each handling the real-time data acquisition, processing and control of a subsystem or component within the apparatus. For example, one processing subsystem may be dedicated to servo control of the substrate positioner PW. Separate units may even handle coarse and fine actuators, or different axes. Another unit might be dedicated to the readout of the position sensor IF. Overall control of the apparatus may be controlled by a central processing unit, communicating with these sub-systems processing units, with operators and with other apparatuses involved in the lithographic manufacturing process.

Figure 1(b) illustrates the known steps to expose target portions (e.g. dies) on a substrate W in the dual stage apparatus of Figure 1(a). On the left hand side within a dotted box are steps performed at a measurement station MEA, while the right hand side shows steps performed at the exposure station EXP. From time to time, one of the substrate tables WTa, WTb will be at the exposure station, while the other is at the measurement station, as described above. For the purposes of this description, it is assumed that a substrate W has already been loaded into the exposure station. At step 100, a new substrate W' is loaded to the apparatus by a mechanism not shown. These two substrates are processed in parallel in order to increase the throughput of the lithographic apparatus. Referring initially to the newly-loaded substrate W', this may be a previously unprocessed substrate, prepared with a new photo resist for first time exposure in the apparatus. In general, however, the lithography process described will be merely one step in a series of exposure and processing steps, so that substrate W' has been through this apparatus and/or other lithography apparatuses, several times already, and may have subsequent processes to undergo as well.

The previous and/or subsequent processes may be performed in other lithography apparatuses, as just mentioned, and may even be performed in different types of lithography apparatus. For example, some layers in the device manufacturing process which are very demanding in parameters such as resolution and overlay may be performed in a more advanced lithography tool than other layers that are less demanding. Therefore some layers may be exposed in an immersion type lithography tool, while others are exposed in a 'dry' tool. Some layers may be exposed in a tool working at DUV wavelengths, while others are exposed using EUV wavelength radiation.

At 102, alignment measurements using the substrate marks P1 etc. and image sensors (not shown) are used to measure and record alignment of the substrate relative to substrate table WTa/WTb. In addition, several alignment marks across the substrate W' will be measured, to establish a "wafer grid", which maps very accurately the distribution of marks across the substrate, including any distortion relative to a nominal rectangular grid. At step 104, a map of wafer height against X-Y position is measured also, for use in accurate focusing of the exposed pattern.

When substrate W' was loaded, recipe data 106 were received, defining the exposures to be performed, and also properties of the wafer and the patterns previously made and to be made upon it. To these recipe data are added the measurements of wafer position, wafer grid and height map that were made at 102, 104, so that a complete set of recipe and measurement data 108 can be passed to the exposure stage. The measurements of alignment data for example comprise X and Y positions of alignment targets formed in a fixed or nominally fixed relationship to the product patterns that are the product of the lithographic process. These alignment data, taken just before exposure, are combined and interpolated to provide parameters of an alignment model. These parameters and the alignment model will be used during the exposure operation to correct positions of patterns applied in the current lithographic step. A conventional alignment model might comprise four, five or six parameters, together defining translation, rotation and scaling of the 'ideal' grid, in different dimensions. As described further below, advanced models are known that use more parameters.

At 110, wafers W' and W are swapped, so that the measured substrate W' becomes the substrate W entering the exposure station EXP. This swapping is performed by exchanging the supports WTa and WTb within the apparatus, so that the substrates W, W' remain accurately clamped and positioned on those supports, to preserve relative alignment between the substrate tables and substrates themselves. Accordingly, once the tables have been swapped, determining the relative position between projection system PS and substrate table WTb (formerly WTa) is all that is necessary to make use of the measurement information 102, 104 for the substrate W (formerly W') in control of the exposure steps. At step 112, reticle alignment is performed using the mask alignment marks M1, M2. In steps 114, 116, 118, scanning motions and radiation pulses are applied at successive target locations across the substrate W, in order to complete the exposure of a number of patterns. By using the alignment data and height map obtained at the measuring station in the performance of the exposure steps, these patterns are accurately aligned with respect to the desired locations, and, in particular, with respect to features previously laid down on the same substrate. The exposed substrate, now labeled W" is unloaded from the apparatus at step 120, to undergo etching or other processes, in accordance with the exposed pattern.

It is desirable to be able to predict a measure of how many devices manufactured in a semiconductor manufacturing process (e.g., including one or more of lithographic, etch and/or deposition steps) such as described above will be functional, e.g., as a percentage of total devices manufactured or otherwise. Such a measure may be referred to as yield. Yield learning processes may be used to find and eliminate each defect type until a device can be manufactured according to specification.

Yield can be measured via voltage contrast (VC) inspection. Briefly, VC inspection comprises applying a voltage to a particular feature and measuring its contrast using a suitable metrology tool such as an e-beam tool or other electron microscope. Under these conditions, the contrast is a direct measure of the conductivity of a feature, and as such a defect determination can be made for the feature (i.e., determining it to be defective if insufficiently conductive when meant to be conductive or *vice versa*). A die may be considered to be non-yielding (defective) if it contains a single defect.

VC inspection is very slow, and therefore cannot be performed in a production setting, e.g., continuously monitoring if sets of wafers (i.e., lots) yield sufficiently for particular settings, patterns and/or conditions. It may be desirable, for example, to predict yield routinely or occasionally during a semiconductor manufacturing process (e.g., every lot, every few lots, every day etc.), so as to ascertain that the semiconductor manufacturing processing performance remains acceptable. VC inspection is typically too slow for this.

To address this, it has been proposed to perform metrology or inspection other than VC inspection to measure a performance parameter, and use a suitable (e.g., calibrated) prediction model (e.g., a statistical prediction model) to predict yield from the measured performance parameter. This metrology or inspection may be faster to perform than VC inspection, and therefore usable in the settings described above. One performance parameter which may be used is edge placement error (EPE), which is a measure of the relative displacement of features (e.g., of edges thereof) from their intended position. Such metrology or inspection may use an e-beam tool or other electron microscope (e.g., scanning electron microscope SEM) to obtain images of the structure, from which the performance parameter can be determined. Alternatively, or in addition, methods of measuring EPE using scatterometry or other optical metrology techniques have been described. Such metrology or inspection may be performed before etch (i.e., after development inspection ADI) or after etch (i.e., after etch inspection AEI).

The calibrated prediction model may be calibrated in a calibration step. Such a calibration step may comprise obtaining calibration performance parameter metrology data (e.g., EPE metrology data), for example obtained using an e-beam tool or electron microscope on at least one calibration wafer, and corresponding reference data (e.g., yield proxy data such as VC inspection data) from the same structures on the same calibration wafer(s). A prediction model (e.g., a probability model) may be calibrated to predict a yield probability or failure probability (i.e., as determined by the reference data) based on performance parameter metrology data.

By way of a specific example, the failure probability $p_f$ may be written in terms of a probability density function *PDF:*

$$p_f = 1 - \int_l^u PDF\,(x, m, \sigma, \vec{\gamma})\mathrm{d}x \qquad [1]$$

where x is the performance parameter metrology (e.g., EPE), *l, u* are the lower and upper specs, m is the location parameter of the underlying distribution, $\sigma$ is the scale parameter, and $\vec{\gamma}$ denotes any other calibration parameters (if applicable, this is optional). Such other calibration parameters may include for example one or both of a skewness calibration parameter and/or a kurtosis calibration parameter.

However, it has been observed that the yield prediction of such a model is not as accurate as it could be; i.e., correlation between the EPE based prediction using such a model and VC inspection based prediction could be improved.

The inventor has determined that the main reasons for yield prediction discrepancy are an under or over-estimation of the distribution scale and uncertainty of specifications. It has also been observed that there is a significant error of the location parameter.

Based on this insight, the inventor proposes to parametrize the failure probability prediction $p_f$ model to include one or more calibration parameters, wherein the one or more calibration parameters include: one or two specification calibration parameters, a scaling calibration parameter $\alpha$ and a location parameter nuisance (or uncertainty) calibration parameter (e.g., mean shift) $\Delta m$. The specification calibration parameters may comprise setting one or both of the lower specification calibration parameter $l$ and upper specification calibration parameter u as a parameter to be optimized or alternatively defining a lower specification delta calibration parameter $\Delta l$ and/or or upper specification delta calibration parameter $\Delta u$ (e.g., lower and/or upper specification correction calibration parameters, being additive to correct the lower and/or upper specification).

The location parameter nuisance calibration parameter $\Delta m$ and specification delta calibration parameters $\Delta l$, $\Delta u$ may each comprise an additive term for its respective parameter. The scaling calibration parameter $\alpha$ may scale the scale parameter (e.g., a multiplicative uncertainty term for the scale parameter).

By way of a specific example, the statistical prediction model or failure probability $p_f$ prediction model may take the form:

$$p_f(\alpha, \Delta m, \Delta l, \Delta u) = 1 - \int_{l+\Delta l}^{u+\Delta u} PDF\,(x, m + \Delta m, \alpha\sigma, \vec{\gamma})\mathrm{d}x \quad [2]$$

An optimization may be performed to optimize the calibration parameters $\alpha$, $\Delta m$, $\Delta l$, $\Delta u$ (or $\alpha$, $\Delta m$, $l$, $u$).

The formulation [2] does not make any assumptions; however, it may be assumed in practice that scaling calibration parameter $\alpha$ and the specification delta calibration parameters $\Delta l$, $\Delta u$ (i.e., the specifications $l$, $u$) are each position independent. For example, they may be most likely properties of the process and measurement tool. By contrast, it may be assumed that the location parameter nuisance calibration parameter $\Delta m$ is position/location dependent. For example, parameter $\Delta m$ most likely represents effects such as overlay measurement error or modeling residuals, and is in its nature a stochastic parameter.

Additionally and optionally, an independent failure probability $1 - p_{other}$ may be included which represents failures resultant from non-imaging sources e.g., material defect related failures. In such a case, the failure probability $p_f$ model may take the form:

$$p_f(\alpha, \Delta m, \Delta l, \Delta u) = 1 - p_{other} \int_{l+\Delta l}^{u+\Delta u} PDF\,(x, m + \Delta m, \alpha\sigma, \vec{\gamma})\mathrm{d}x \quad [3]$$

However, although conceptually justified, this mechanism has not been observed in practice. This may mean that such material related failures are unlikely and not measurable given the attainable sampling rates. As such the model of Equation [2] may be sufficient to implement the concepts herein.

Specific model implementations

The degree of difficulty entailed in incorporating the aforementioned calibration parameters into a model depends on the specific distribution model used. For example, if a normal distribution $PDF_{\mathcal{N}}$ and/or split-normal distribution $PDF_{S\mathcal{N}}$ is used then incorporating the calibration parameters is trivial, as these distributions already comprise explicit scale and location parameters. Examples of such models may comprise:

$$PDF_{\mathcal{N}}(m + \Delta m, \alpha\sigma) = \frac{1}{\alpha\sigma\sqrt{(2\pi)}} \exp\left(-\frac{1}{2}\left(\frac{x - m - \Delta m}{\alpha\sigma}\right)^2\right) \quad [4]$$

$$PDF_{\mathcal{SN}}(m + \Delta m, \alpha\sigma, \epsilon) = \begin{cases} \dfrac{1}{\alpha\sigma\sqrt{(2\pi)}} \exp{-\dfrac{1}{2}\left(\dfrac{x - m - \Delta m}{\alpha\sigma(1 - \epsilon)}\right)^2} , \; x - m - \Delta m \leq 0 \\ \dfrac{1}{\alpha\sigma\sqrt{(2\pi)}} \exp{-\dfrac{1}{2}\left(\dfrac{x - m - \Delta m}{\alpha\sigma(1 + \epsilon)}\right)^2} , \; otherwise \end{cases} \qquad [5]$$

For a Gaussian mixture model $PDF_{\mathcal{GMM}}$ there is no explicit location parameter and scale parameter, but these can be derived from the individual component scales, locations and weights. Specifically the location of the mixture model can be expressed as:

$$m = a_1 m_1 + a_2 m_2 + a_3 m_3$$

Transforming m as such is trivial, but the model needs to be written in terms of distances to the location $i$, i.e., $\Delta m_i = m - m_i$. The $\alpha$ parameter has effect on both scaling parameter $\sigma_i$ and distance $m - m_i$.

$$PDF_{\mathcal{GMM}} = \sum_i w_i\, PDF_{\mathcal{N}}(m - \alpha(m - m_i) + \Delta m, \alpha\sigma_i) \qquad [6]$$

where $w_i$ are the weights of the Gaussian mixture model.

Optimization

The proposed method comprises a calibration stage in which the calibration parameters are determined based on calibration performance parameter metrology data (e.g., EPE metrology data) and corresponding reference data. The calibration performance parameter metrology data may comprise a set of performance parameter (e.g., EPE) distributions per location ($m_i$, $\sigma_i$, $\vec{\gamma}_i$), i.e., the EPE metrology data may be transformed into EPE probability distributions. The reference data may comprise a corresponding set of yield proxy measurements ($n_i^{OK}$, $n_i^{NOK}$), each comprising a pair of values respectively of successes $n_i^{OK}$ and failures $n_i^{NOK}$ at the ith measurement location.

A likelihood $\mathcal{L}$ may be constructed which is parametrized with the calibration parameters $\alpha$, $\overrightarrow{\Delta m}$, $l$, $u$ (or $\alpha$, $\Delta m$, $\Delta l$, $\Delta u$). The negative logarithm (log-likelihood) of this likelihood function is minimized to calibrate the calibration parameters. In other words, this optimization calibrates the calibration parameters so as to maximize the likelihood of observing the reference data given the calibration performance parameter metrology data.

Calibrating the calibration parameters as described herein reduces or minimizes yield prediction discrepancies due to under- or over-estimation of the distribution scale and/or location parameters and/or uncertainty of the specifications.

As the number of observed failures and success should follow a binomial distribution, the likelihood may be expressed as:

$$-\log\mathcal{L} = -\sum_i^{N_{locs}} n_i^{OK} \log(1 - p_f) + n_i^{NOK}\log p_f \qquad [7]$$

In order to prevent overfitting and to model a physically realistic system, the optimization may be regularized, e.g., by adding a penalty term on the amplitude of the location parameter nuisance calibration parameter (mean shift parameter) $\Delta m$. Such a penalty term may prevent overfitting such that the whole variation of the data is explained solely or predominately by this mean shift. Therefore, the likelihood may comprise a penalized likelihood:

$$-\log\mathcal{L} = -\sum_i^{N_{locs}} n_i^{OK} \log(1 - p_f) + n_i^{NOK}\log p_f - \frac{\Delta m_i^2}{2\sigma_{noise}^2} \qquad [8]$$

Noise hyperparameter $\sigma_{noise}$ is not estimated by the model, but is user-defined. For example, it may be known *à priori* based on e.g., an expected overlay measurement error. This is not always desirable and/or possible because the underlaying physical mechanism is not known. Instead, the noise hyperparameter may be determined by the following heuristic.

The calibration parameters $l$, $u$, $\alpha$ are not location dependent and therefore should not depend on a sub-selection of the data. Clearly some random error is to be expected, but in general different sub-samplings should yield approximately the same values for these calibration parameters $l$, $u$, $\alpha$. Based on this insight, it can be postulated that the correct noise hyperparameter $\sigma_{noise}$ value is that which provides the lowest sensitivity of the estimated parameters to sub-selecting (e.g., clipping) of the data. A given dataset can always be clipped provided that the estimation procedure will converge. This can be practically implemented using a direct search approach on a uniform grid, because the scale of the residuals is known à priori.

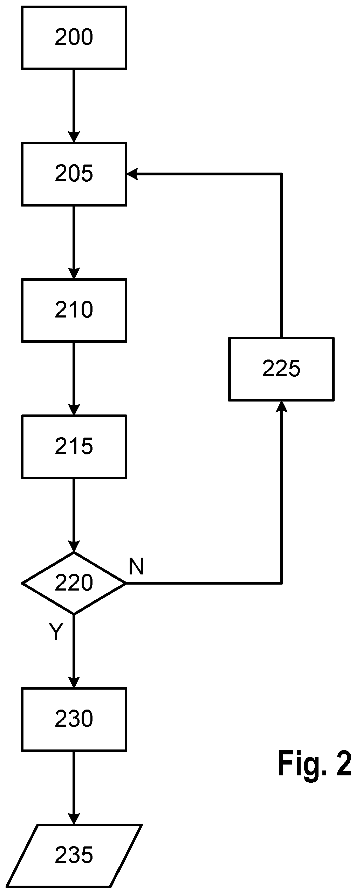

Figure 2 is a flowchart (where rectangles are steps, the diamond is a decision and the trapezoid is data) describing such a noise hyperparameter $\sigma_{noise}$ optimization method which may be used to determine a nominally optimal value of the noise hyperparameter.

The method comprises a direct search approach on a finite set of noise hyperparameter values, e.g., $\sigma_{noise} \in \{0, 0.1, \dots 10\}$. Noise is initially set to an initial value at step 200, e.g., $\sigma_{noise} = 0$. The one or more of the calibration parameters $l$, $u$, $\alpha$ are estimated, at step 205, using a first data range (e.g., the full data range) to obtain first data range calibration parameters and then estimated, at step 210, using a second data range (e.g., a reduced/clipped range, i.e., a proper subset of the full data range) to obtain second data range calibration parameters. A difference of the first data range calibration parameters and second data range calibration parameters per calibration parameter is calculated at step 215. At step 220, it is determined whether the end of the set of noise hyperparameter values has been reached; e.g., the method may be performed over a set of noise hyperparameter values covering a range starting from the initial value set at step 200 and ending at a maximum (or minimum) value, the latter indicating the end of the set. If not N, the noise hyperparameter value is incremented 225 and steps 205 to 220 repeated incrementally for all noise hyperparameter values in the finite set, until the end of the set of noise hyperparameter values has been reached Y. Based on the calculated difference values determined at step 215, an optimized noise hyperparameter value 235 is selected 230.

The selection 230 of the optimized noise hyperparameter value 235 may be performed using a cost function which determines the smallest sum of absolute values of the relative calibration parameter differences obtained using the first and second data ranges; for example:

$$\underset{\sigma_{noise}}{\mathrm{argmin}} \left| \frac{\alpha_1 - \alpha_{0.9}}{\alpha_1} \right| + \left| \frac{l_1 - l_{0.9}}{\alpha_1 \bar{\sigma}} \right| + \left| \frac{u_1 - u_{0.9}}{\alpha_1 \bar{\sigma}} \right| \qquad [9]$$

where the subscript 1 indicates a respective calibration parameter estimated on the first data range and the subscript 0.9 indicates a respective calibration parameter estimated on the second data range.

It can be shown that the addition of the regularization term greatly improves calibration parameter stability. For example, with such regularization, the calibration parameter determination remains stable when conditioning on only small data ranges; e.g., a calibration data set comprising yields of 50% or above (e.g., where the lower yield limit is 50%) yields of 60% or above, yields of 70% or above, yields of 80% or above, yields of 90% or above. Without such regularization, the calibration parameter inference may become unstable when the lower yield limit of the calibration data is 50% or more. This means that the calibration parameters are determined with improved accuracy when conditioning on more realistic yield ranges. This improves prediction performance of a model conditioned on such yield ranges and/or obviates the need provide a special calibration wafer with much larger yield ranges having lower yield limits well below 50%.

Practical optimization procedure

In practice, the calibration parameters may be estimated by minimizing the negative log-likelihood numerically while taking into account constraints for the calibration parameters, more specifically: $\alpha > 0$ and $l \le u$:

$$\underset{\alpha, l, u, \vec{m}}{\mathrm{argmin}} - \log \mathcal{L}$$
$$[10]$$
$$\alpha > 0$$
$$l < u$$

where $-\log \mathcal{L}$ is as defined in equation [8] (or equation [7] in a non-regularized example).

In order to be tractable, the failure probability $p_f$ term can be rewritten in terms of cumulative distribution functions *CDF* rather than a probability density function *PDF,* e.g.:

$$p_f = 1 - CDF(u) + CDF(l) \qquad [11]$$

The generic optimization problem can therefore be recast as:

$$\operatorname*{argmin}_{\alpha,l,u,\vec{\Delta m}} - \sum_{i}^{N_{locs}} n_i^{OK} \log\big(CDF(u) - CDF(l)\big) + n_i^{NOK} \log\big(1 - CDF(u) + CDF(l)\big) - \frac{\Delta m_i^2}{2\sigma_{noise}^2} \qquad [12]$$

$$\alpha > 0$$
$$l < u$$

In such embodiment, using a normal distribution, the $\mathrm{CDF}_{\mathcal{N}}$ including the calibration parameters may take the following form:

$$\mathrm{CDF}_{\mathcal{N}} = \frac{1}{2}\left(1 + \mathrm{erf}\left(\frac{x - m - \Delta m}{\alpha\sigma\sqrt{2}}\right)\right) \qquad [13]$$

For a split normal, the $\mathrm{CDF}_{f,\mathcal{SN}}$ may take the form:

$$\mathrm{CDF}_{f,\mathcal{SN}} = \begin{cases} \alpha(1-\epsilon) + \alpha(1-\epsilon)\mathrm{erf}\left(\dfrac{x - m - \Delta m}{\alpha\sigma(1-\epsilon)\sqrt{2}}\right), & x \le m + \Delta m \\[3mm] \alpha(1-\epsilon) + \alpha(1+\epsilon)\mathrm{erf}\left(\dfrac{x - m - \Delta m}{\alpha\sigma(1+\epsilon)\sqrt{2}}\right), & otherwise \end{cases} \qquad [14]$$

For a Gaussian mixture model, the probability $\mathrm{CDF}_{f,\mathcal{GMM}}$ can be expressed as

$$\mathrm{CDF}_{f,\mathcal{GMM}} = \sum_{i} \frac{w_i}{2}\left(1 + \mathrm{erf}\left(\frac{x - \alpha m_i - (1-\alpha)m - \Delta m}{\alpha\sigma_i\sqrt{2}}\right)\right),$$
$$m = \sum_{i} w_i\, m_i \qquad [15]$$

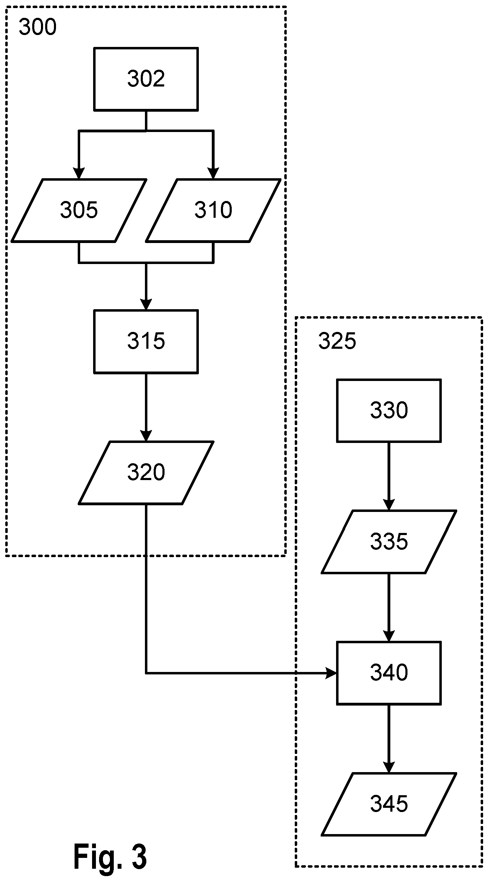

Figure 3 is a flowchart describing a yield prediction method which implements the concepts described herein. A calibration stage 300 may comprise measuring calibration performance parameter metrology data and reference data on a calibration wafer 302 (which may comprise a production wafer or a specific calibration wafer for example). The calibration performance parameter metrology data may comprise EPE data for example. The calibration performance parameter metrology data may be measured using an e-beam tool, electron microscope or any tool capable of EPE metrology. The reference data may use any reference inspection or metrology method capable of measuring ground truth data for yield (yield proxy data), e.g., VC inspection. This step provides calibration performance parameter metrology data (e.g., EPE data) 305 and reference data (e.g., VC inspection data or yield data) 310. Step 315 comprises applying the concepts disclosed herein to calibrate one or more of the calibration parameters as have been described. This step yields optimized calibration parameter values 320.

In a production phase (or any other yield prediction phase) 325, such as a continuous monitoring phase, a monitoring wafer (which may comprise a production wafer or otherwise) is measured 330 to obtain performance parameter metrology data 335. The calibration model 340, as calibrated using optimized calibration parameter values 320, is used to map the performance parameter metrology data 335 to predicted yield 345.

This production phase may optionally use in-line metrology (e.g., e-beam metrology) data and the calibration model 340 for such yield prediction, without the need for VC metrology data other than for initial model calibration/reference data.

The predicted yield 345 may be used to determine whether process corrections are required, e.g., as corrections in any one or more of: any one or more semiconductor manufacturing processes, recipe determination, illumination determination, reticle pattern determination (e.g., source mask optimization/and or optical proximity control) and/or any other aspect or process on which yield depends.

The calibration methods described herein show particular improvement over current methods when the calibration data comprises a limited range. For example, it may be that the range of yield values in calibration data does not typically fall below a particular value as very low yield (e.g., below 80% or below 70%) is not typically encountered in a lithographic process. Increasing the data range is difficult and would require special calibration wafers to be exposed (i.e., the model could not be conditioned on production wafers or wafers exposed according to production conditions). Calibrated models such as described by Equation [1] conditioned on such limited ranges show limited performance in predicting yield. A model conditioned according to the concepts described herein demonstrates significantly improved prediction performance, i.e., improved correlation between a model based prediction using EPE data and corresponding VC inspection data.

While the performance parameter is described as EPE in the examples above, the performance parameter may comprise any other performance parameter indicative of yield, including any feature position metric other than EPE, such as for example critical dimension (CD).

Implementation

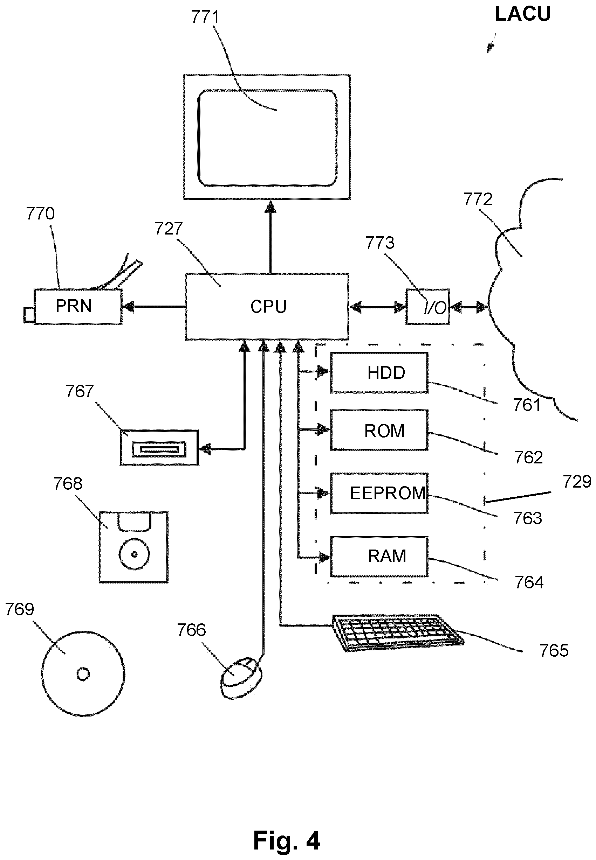

The steps of the methods described above can be automated within the lithography apparatus control unit LACU shown in Figure 1(a) and/or any processing unit within a metrology tool and/or any stand-alone processing unit. In either case, the LACU or processing unit may comprise a computer assembly as shown in Figure 4. The computer assembly may be a dedicated computer in the form of a control unit in embodiments of the assembly according to concepts disclosed herein or, alternatively, be a central computer controlling the lithographic apparatus/metrology apparatus and/or processing unit. The computer assembly may be arranged for loading a computer program product comprising computer executable code. This may enable the computer assembly, when the computer program product is downloaded, to control aforementioned uses of a lithographic apparatus.

Memory 729 connected to processor 727 may comprise a number of memory components like a hard disk 761, Read Only Memory (ROM) 762, Electrically Erasable Programmable Read Only Memory (EEPROM) 763 and/or Random Access Memory (RAM) 764. Not all aforementioned memory components need to be present. Furthermore, it is not essential that aforementioned memory components are physically in close proximity to the processor 727 or to each other. They may be located at a distance away.

The processor 727 may also be connected to some kind of user interface, for instance a keyboard 765 or a mouse 766. A touch screen, track ball, speech converter or other interfaces that are known to persons skilled in the art may also be used.

The processor 727 may be connected to a reading unit 767, which is arranged to read data, e.g. in the form of computer executable code, from and under some circumstances store data on a data carrier, like a floppy disc 768 or a CDROM 769. Also DVD's or other data carriers known to persons skilled in the art may be used.

The processor 727 may also be connected to a printer 770 to print out output data on paper as well as to a display 771, for instance a monitor or LCD (Liquid Crystal Display), of any other type of display known to a person skilled in the art.

The processor 727 may be connected to a communications network 772, for instance a public switched telephone network (PSTN), a local area network (LAN), a wide area network (WAN) etc. by means of transmitters/receivers 773 responsible for input/output (I/O). The processor 727 may be arranged to communicate with other communication systems via the communications network 772. In an embodiment of the invention external computers (not shown), for instance personal computers of operators, can log into the processor 727 via the communications network 772.

The processor 727 may be implemented as an independent system or as a number of processing units that operate in parallel, wherein each processing unit is arranged to execute sub-tasks of a larger program. The processing units may also be divided in one or more main processing units with several sub-processing units. Some processing units of the processor 727 may even be located a distance away of the other processing units and communicate via communications network 772. Connections between modules can be made wired or wireless.

The computer system can be any signal processing system with analogue and/or digital and/or software technology arranged to perform the functions discussed here.

Further embodiments are disclosed in the subsequent numbered clauses:

1. A method for calibrating a prediction model for predicting a failure probability of a device manufactured by a semiconductor manufacturing process based on performance parameter data relating to a performance parameter of said device, the method comprising:

obtaining calibration performance parameter data comprising values for the performance parameter;
obtaining reference data corresponding to said calibration performance parameter data;
optimizing one or more calibration parameters of the prediction model so as to improve prediction performance of said prediction model in predicting said reference data based on said calibration performance parameter data;
wherein said one or more calibration parameters comprises one or more of: an upper specification calibration parameter or an upper specification delta calibration parameter thereof, a lower specification calibration parameter or lower specification delta calibration parameter thereof, a scaling calibration parameter for scaling a scale parameter of the prediction model, a location parameter nuisance calibration parameter, a skewness calibration parameter and/or a kurtosis calibration parameter.

2. A method according to clause 1, wherein said one or more calibration parameters comprises two or more of: the upper specification calibration parameter or upper specification delta calibration parameter thereof, the lower specification calibration parameter or lower specification delta calibration parameter thereof, the scaling calibration parameter and/or the location parameter nuisance calibration parameter.

3. A method according to clause 1, wherein said one or more calibration parameters comprises each of: the upper specification calibration parameter or upper specification delta calibration parameter thereof, the lower specification calibration parameter or lower specification delta calibration parameter thereof, the scaling calibration parameter and/or the location parameter nuisance calibration parameter.

4. A method according to any preceding clause, wherein said optimizing step comprises optimizing a likelihood of observing the reference data given the calibration performance parameter metrology data, by optimizing a function parameterized by said one or more calibration parameters.

5. A method according to any preceding clause, wherein said optimizing step comprises optimizing a likelihood function parameterized by said one or more calibration parameters.

6. A method according to any preceding clause, wherein said optimizing step is regularized to include an amplitude penalty on the location parameter nuisance calibration parameter.

7. A method according to clause 6, wherein said amplitude penalty on the location parameter nuisance calibration parameter is scaled by a noise hyperparameter.

8. A method according to clause 7, comprising determining said noise hyperparameter as that for which one or more of the the upper specification calibration parameter or upper specification delta calibration parameter thereof, the lower specification calibration parameter or lower specification delta calibration parameter thereof and/or the scaling calibration parameter show minimal sensitivity to sub-selection of said calibration performance parameter data and/or reference data.

9. A method according to clause 7 or 8, comprising:

determining each of said one or more of the the upper specification calibration parameter or upper specification delta calibration parameter thereof, the lower specification calibration parameter or lower specification delta calibration parameter thereof and/or the scaling calibration parameter using a first data range of said calibration performance parameter data and/or reference data to obtain first data range calibration parameters;
determining each of said one or more of the the upper specification calibration parameter or upper specification delta calibration parameter thereof, the lower specification calibration parameter or lower specification delta calibration parameter thereof and/or the scaling calibration parameter using a second data range of said calibration performance parameter data and/or reference data to obtain second data range calibration parameters;
determining a difference between the first data range calibration parameters and second data range calibration parameters; and
determining said noise hyperparameter as that which minimizes the sum of absolute values of said differences.

10. A method according to any preceding clause, wherein said prediction model comprises a probability density function or equivalent cumulative distribution functions describing said failure probability, parameterized by said one or more calibration parameters.

11. A method according to any preceding clause, wherein said prediction model comprises a normal distribution model, split normal distribution model or Gaussian mixture model, parameterized by said one or more calibration parameters.

12. A method according to any preceding clause, wherein said an upper specification calibration parameter or an upper specification delta calibration parameter thereof, lower specification calibration parameter or lower specification delta calibration parameter thereof and scaling calibration parameter are each assumed to be location independent.

13. A method according to any preceding clause, wherein said location parameter nuisance calibration parameter is assumed to be location dependent.

14. A method according to any preceding clause, wherein said performance parameter comprises edge placement error or other feature position metric.

15. A method according to any preceding clause, wherein said calibration performance parameter data comprises electron microscope data.

16. A method according to any preceding clause, wherein said calibration performance parameter data comprises a set of performance parameter distributions per measurement location.

17. A method according to any preceding clause, wherein said reference data comprises yield proxy data.

18. A method according to any preceding clause, wherein said reference data comprises pairs of successes and failures per measurement location.

19. A method according to any preceding clause, wherein said reference data comprises voltage contrast inspection data.

20. A method according to any preceding clause, wherein said calibration performance parameter data and/or reference data relates to a lower yield limit of 50%.

21. A method according to any preceding clause, wherein said calibration performance parameter data and/or reference data relates to a lower yield limit of 70%.

22. A method according to any preceding clause, wherein said calibration performance parameter data and reference data are obtained from common one or more substrates.

23. A method according to clause 22, comprising measuring said one or more substrates to obtain said calibration performance parameter data and reference data.

24. A method for predicting a failure probability of a device manufactured by a semiconductor manufacturing process based on performance parameter data relating to a performance parameter of said device, the method comprising:

> obtaining performance parameter data comprising values for the performance parameter;
> obtaining a prediction model for which one or more calibration parameters of the prediction model have been calibrated;
> wherein said one or more calibration parameters comprises one or more of: an upper specification calibration parameter or an upper specification delta calibration parameter thereof, a lower specification calibration parameter or lower specification delta calibration parameter thereof, a scaling calibration parameter for scaling a scale parameter of the prediction model, a location parameter nuisance calibration parameter, a skewness calibration parameter and/or a kurtosis calibration parameter.

25. A method according to clause 24, wherein said prediction model has been calibrated using the method of any of clauses 1 to 23.

26. A method according to any preceding clause wherein said semiconductor manufacturing process comprises one or more of: a lithographic process, imprint process, deposition process and/or an etch process.

27. A computer program comprising computer readable instructions which, when run on suitable processor, cause the processor to perform the method of any one of clauses 1 to 26.

28. A computer program product comprising the computer program of clause 27.

29. A processing arrangement comprising:

> a processor; and
> a computer program product comprising computer readable instructions which, when run on said processor, cause the processor to perform the method of any one of clauses 1 to 26.

30. A metrology apparatus comprising:
the processing arrangement of clause 29.

31. A metrology apparatus according to clause 30, comprising either: a scanning electron microscope, an e-beam microscope, a scatterometer or a holographic microscope.

32. A semiconductor manufacturing apparatus comprising:
the processing arrangement of clause 29.

33. A semiconductor manufacturing apparatus according to clause 32 comprising one or more of:
a lithographic apparatus, an imprint apparatus, a deposition apparatus and/or an etch apparatus.

Although specific reference may be made in this text to the use of lithographic apparatus in the manufacture of ICs, it should be understood that the lithographic apparatus described herein may have other applications, such as the manufacture of integrated optical systems, guidance and detection patterns for magnetic domain memories, flat-panel displays, liquid-crystal displays (LCDs), thin-film magnetic heads, etc. The skilled artisan will appreciate that, in the context of such alternative applications, any use of the terms "wafer" or "field"/"die" herein may be considered as synonymous with the more general terms "substrate" or "target portion", respectively. The substrate referred to herein may be processed, before or after exposure, in for example a track (a tool that typically applies a layer of resist to a substrate and develops the exposed resist), a metrology tool and/or an inspection tool. Where applicable, the disclosure herein may be applied to such and other substrate processing tools. Further, the substrate may be processed more than once, for example in order to create a multi-layer IC, so that the term substrate used herein may also refer to a substrate that already contains multiple processed layers.

Although specific reference may have been made above to the use of embodiments of the invention in the context of optical lithography, it will be appreciated that the invention may be used in other applications, for example imprint lithography, and where the context allows, is not limited to optical lithography. In imprint lithography a topography in a patterning device defines the pattern created on a substrate. The topography of the patterning device may be pressed into a layer of resist supplied to the substrate whereupon the resist is cured by applying electromagnetic radiation, heat, pressure or a combination thereof. The patterning device is moved out of the resist leaving a pattern in it after the resist is cured.

The terms "radiation" and "beam" used herein encompass all types of electromagnetic radiation, including ultraviolet (UV) radiation (e.g. having a wavelength of or about 365, 248, 193, 157 or 126 nm) and extreme ultra-violet (EUV) radiation (e.g. having a wavelength in the range of 5-20 nm), as well as particle beams, such as ion beams or electron beams.

The term "lens", where the context allows, may refer to any one or combination of various types of optical components, including refractive, reflective, magnetic, electromagnetic and electrostatic optical components.

While specific embodiments of the invention have been described above, it will be appreciated that the invention may be practiced otherwise than as described. For example, the invention may take the form of a computer program containing one or more sequences of machine-readable instructions describing a method as disclosed above, or a data storage medium (e.g. semiconductor memory, magnetic or optical disk) having such a computer program stored therein.

The descriptions above are intended to be illustrative, not limiting. Thus, it will be apparent to one skilled in the art that modifications may be made to the invention as described without departing from the scope of the claims set out below. In addition, it should be appreciated that structural features or method steps shown or described in any one embodiment herein can be used in other embodiments as well.

## Claims

1.  A method for calibrating a prediction model for predicting a failure probability of a device manufactured by a semiconductor manufacturing process based on performance parameter data relating to a performance parameter of said device, the method comprising:

    obtaining calibration performance parameter data comprising values for the performance parameter;
    obtaining reference data corresponding to said calibration performance parameter data;
    optimizing one or more calibration parameters of the prediction model so as to improve prediction performance of said prediction model in predicting said reference data based on said calibration performance parameter data;
    wherein said one or more calibration parameters comprises one or more of: an upper specification calibration parameter or an upper specification delta calibration parameter thereof, a lower specification calibration parameter or lower specification delta calibration parameter thereof, a scaling calibration parameter for scaling a scale parameter of the prediction model, a location parameter nuisance calibration parameter, a skewness calibration parameter and/or a kurtosis calibration parameter.

2.  A method as claimed in claim 1, wherein said one or more calibration parameters comprises each of: the upper specification calibration parameter or upper specification delta calibration parameter thereof, the lower specification calibration parameter or lower specification delta calibration parameter thereof, the scaling calibration parameter and/or the location parameter nuisance calibration parameter.

3.  A method as claimed in any preceding claim, wherein said optimizing step comprises minimizing a negative log-likelihood function parameterized by said one or more calibration parameters.

4.  A method as claimed in any preceding claim, wherein said optimizing step is regularized to include an amplitude penalty on the location parameter nuisance calibration parameter.

5.  A method as claimed in claim 4, wherein said amplitude penalty on the location parameter nuisance calibration parameter is scaled by a noise hyperparameter, the method comprising determining said noise hyperparameter as that for which one or more of the the upper specification calibration parameter or upper specification delta calibration parameter thereof, the lower specification calibration parameter or lower specification delta calibration parameter thereof and/or the scaling calibration parameter show minimal sensitivity to sub-selection of said calibration performance parameter data and/or reference data.

6. A method as claimed in any preceding claim, wherein said prediction model comprises a probability density function or equivalent cumulative distribution functions describing said failure probability, parameterized by said one or more calibration parameters.

7. A method as claimed in any preceding claim, wherein said prediction model comprises a normal distribution model, split normal distribution model or Gaussian mixture model, parameterized by said one or more calibration parameters.

8. A method as claimed in any preceding claim, wherein said an upper specification calibration parameter or an upper specification delta calibration parameter thereof, lower specification calibration parameter or lower specification delta calibration parameter thereof and scaling calibration parameter are each assumed to be location independent; and said location parameter nuisance calibration parameter is assumed to be location dependent.

9. A method as claimed in any preceding claim, wherein said performance parameter comprises edge placement error or other feature position metric.

10. A method as claimed in any preceding claim, wherein said calibration performance parameter data comprises a set of performance parameter distributions per measurement location.

11. A method as claimed in any preceding claim, wherein said reference data comprises yield proxy data.

12. A method for predicting a failure probability of a device manufactured by a semiconductor manufacturing process based on performance parameter data relating to a performance parameter of said device, the method comprising:

    obtaining performance parameter data comprising values for the performance parameter;
    obtaining a prediction model for which one or more calibration parameters of the prediction model have been calibrated;
    wherein said one or more calibration parameters comprises one or more of: an upper specification calibration parameter or an upper specification delta calibration parameter thereof, a lower specification calibration parameter or lower specification delta calibration parameter thereof, a scaling calibration parameter for scaling a scale parameter of the prediction model, a location parameter nuisance calibration parameter, a skewness calibration parameter and/or a kurtosis calibration parameter.

13. A method as claimed in claim 12, wherein said prediction model has been calibrated using the method of any of claims 1 to 11.

14. A computer program comprising computer readable instructions which, when run on suitable processor, cause the processor to perform the method of any one of claims 1 to 13.

15. A semiconductor manufacturing apparatus or metrology apparatus comprising:

    a processor; and
    a computer program product comprising computer readable instructions which, when run on said processor, cause the processor to perform the method of any one of claims 1 to 13.

# Fig. 1

(a)

(b)

```
        ┌─────────┐
        │   200   │
        └────┬────┘
             │
             ▼
        ┌─────────┐◄──────────────────┐
        │   205   │                   │
        └────┬────┘                   │
             │                        │
             ▼                        │
        ┌─────────┐            ┌─────────┐
        │   210   │            │   225   │
        └────┬────┘            └────▲────┘
             │                      │
             ▼                      │
        ┌─────────┐                 │
        │   215   │                 │
        └────┬────┘                 │
             │                      │
             ▼                      │
          ◇─────◇   N               │
         ◇  220  ◇─────────────────┘
          ◇─────◇
             │ Y
             ▼
        ┌─────────┐
        │   230   │
        └────┬────┘
             │
             ▼
         ╱─────────╱
        ╱   235   ╱
       ╱─────────╱
```

Fig. 2

Fig. 3

**Fig. 4**

Europäisches
Patentamt

European
Patent Office

Office européen
des brevets

# EUROPEAN SEARCH REPORT

**Application Number**

**EP 24 20 7279**

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2023/076218 A1 (VAN INGEN SCHENAU KOENRAAD [NL] ET AL) 9 March 2023 (2023-03-09) * paragraphs [0392] - [0396] * ----- | 1-15 | INV. G03F7/00 |
| A | "A METHOD OF MONITORING A LITHOGRAPHIC PROCESS AND ASSOCIATED APPARATUSES", RESEARCH DISCLOSURE, KENNETH MASON PUBLICATIONS, HAMPSHIRE, UK, GB, vol. 682, no. 60, 19 January 2021 (2021-01-19), XP007149125, ISSN: 0374-4353 [retrieved on 2021-01-19] * paragraphs [0045], [0046] * ----- | 1-15 | |
| A | WO 2020/114686 A1 (ASML NETHERLANDS BV [NL]) 11 June 2020 (2020-06-11) * paragraphs [0048], [0049] * ----- | 1-15 | |

**TECHNICAL FIELDS SEARCHED (IPC)**

G03F

The present search report has been drawn up for all claims

| Place of search | Date of completion of the search | Examiner |
|---|---|---|
| Munich | 17 April 2025 | Eisner, Klaus |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 20 7279

This annex lists the patent family members relating to the patent documents cited in the above-mentioned European search report.
The members are as contained in the European Patent Office EDP file on
The European Patent Office is in no way liable for these particulars which are merely given for the purpose of information.

17-04-2025

| Patent document cited in search report | Publication date | Patent family member(s) | Publication date |
|---|---|---|---|
| US 2023076218 A1 | 09-03-2023 | CN 115104068 A | 23-09-2022 |
| | | KR 20220127925 A | 20-09-2022 |
| | | TW 202147036 A | 16-12-2021 |
| | | TW 202307592 A | 16-02-2023 |
| | | TW 202414116 A | 01-04-2024 |
| | | US 2023076218 A1 | 09-03-2023 |
| | | WO 2021165419 A1 | 26-08-2021 |
| WO 2020114686 A1 | 11-06-2020 | CN 113168111 A | 23-07-2021 |
| | | EP 3891558 A1 | 13-10-2021 |
| | | KR 20210083348 A | 06-07-2021 |
| | | TW 202030652 A | 16-08-2020 |
| | | US 2022011728 A1 | 13-01-2022 |
| | | WO 2020114686 A1 | 11-06-2020 |

EPO FORM P0459

For more details about this annex : see Official Journal of the European Patent Office, No. 12/82